# EUROPEAN PATENT SPECIFICATION

(11) **EP 2 210 966 B1**
(45) Date of publication and mention of the grant of the patent: **13.07.2011**
(21) Application number: 10275006.4
(22) Date of filing: 25.01.2010
(51) Int. Cl.: C23C 14/35

(54) **A method of plasma vapour deposition**
Verfahren zur Plasmadampfabscheidung
Procédé pour dépôt de vapeur de plasma

(30) Priority: 26.01.2009 GB 0901157
(43) Date of publication of application: 28.07.2010
(73) Proprietor: SPP Process Technology Systems UK Limited, Newport, Gwent NP10 8UJ (GB)
(72) Inventor: Carruthers, Mark, Newport, Gwent NP10 8TB (GB); Burgess, Stephen, Ebbw Vale, Gwent NP23 5NA (GB); Wilby, Anthony, Yate, Bristol BS37 7YJ (GB); Rastogi, Amit, Newport, Gwent NP20 5AE (GB); Rich, Paul, Wotton-Under-Edge, Gloucestershire GL12 (GB); Rimmer, Nicholas, Cardiff, South Glamorgan CF23 5HD (GB)
(74) Representative: Dunlop, Brian Kenneth Charles

(56) References cited:
- US-A- 5 928 480
- US-A1- 2006 169 576
- US-B1- 6 193 855
- KOYANAGI T ET AL: "Effects of He on Cu film formation by rf sputtering" VACUUM ELSEVIER UK, vol. 51, no. 4, December 1998 (1998-12), pages 575-582, XP002582081 ISSN: 0042-207X

## Description

This invention relates to a method of plasma vapour deposition of metal into a recess in a workpiece in a manner to achieve re-sputtering of the metal at the base of the recess onto the sidewalls.

It is known to use ionised metal sputtering techniques involving a high powered unbalanced magnetron discharge source. The metal ions are attracted to the base of a recess formed in a workpiece, such as a semi-conductor wafer, using a DC bias induced by applying RF power to the wafer pedestal. This gives an improved bottom and sidewall coverage in the recess. Further improvement is known to be achievable by re-sputtering the metal already deposited in the base onto the lower and mid parts of the recess sidewall. To achieve re-sputtering DC bias voltages in the range of 50 to 500 volts are required. The higher the DC bias the greater re-sputtering and there is an improvement in the sidewall coverage.

Even so the current results are not satisfactory for all purposes. US6193855 and US5828480 describe metal sputtering processes for depositing metal utilising Ar in a sputter gas.

From one aspect the invention consists of a method as set out in claim 1.

Preferably the ratio is about 20:1.

Preferably the flow rate of Ar is <10 sccm and the flow rate of He is >100 seem. Thus for example the He flow rate may be about 140 sccm and the Ar may be about 7 sccm.

In any of the above cases the metal may be copper.

In a further embodiment the method may be characterised in that the mix of He and Ar is such that the target current density is at least about 0.035 A/cm² and preferably about 0.037 A/cm².

The invention may be performed In various ways and specific embodiments will now be described by way of example with reference to the accompanying drawings in which :
Figure 1 is a cut away view of a DC magnetron ionised deposition sputtering system;
Figure 2 is a table showing a secondary electron emission as a function of bombarding energy and gas types for ions incident on Mo and W targets. This figure Is taken from Glow Discharge Processes, Chapmen, Wiley and Sons 1980;

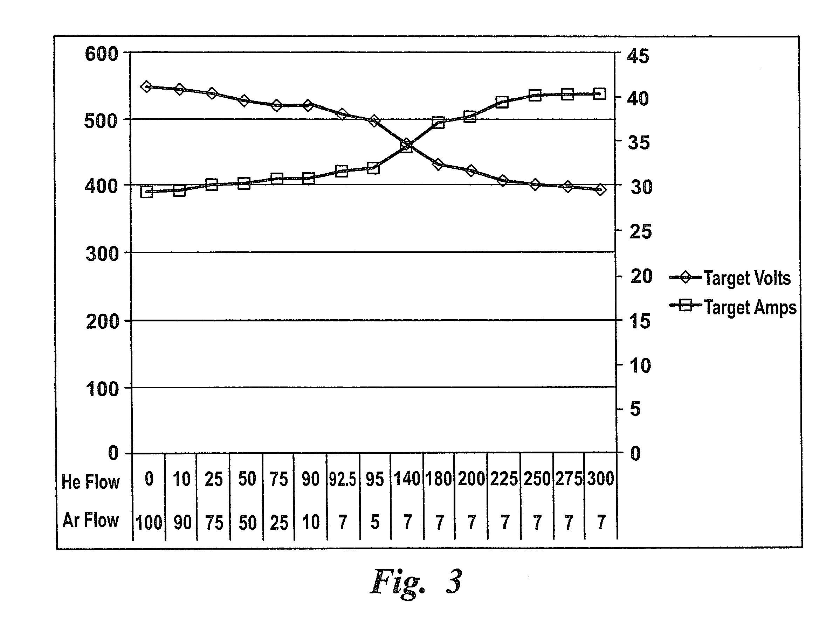

Figure 3 illustrates the variation in target current and voltage with respective flow rates by adding He to the Ar sputter process;
Figure 4 shows the sidewall coverage in a 5:1 trench structure for a standard Ar process;
Figure 5 shows the equivalent view to Figure 4 for an optimised He/Ar process;
Figure 6 is an equivalent view for an He/Ar process with a reduced He flow;
Figure 6 (a), (b), (c) show the effects of He/Ar flow on deposition rate (tooling factor); stress and within wafer non uniformity respectively; and
Figure 7 is an equivalent view to Figure 5 with another He recipe.

In an unbalanced DC Magnetron lonised sputtering deposition system, metal and gas ionisation is achieved through the collision of metal and gas atoms with secondary electrons produced at the target surface. The secondary electrons are accelerated by the negative bias supply to the target surface and achieve high energies, typically 200 to 1000 eV. These high energy secondary electrons collide with metal and gas atoms or molecules and produce ions. Accordingly if the amount of secondary electrons emitted from the target could be increased then there would be an increase in the ionisation fraction that is the ratio of ions to neutrals from any species.

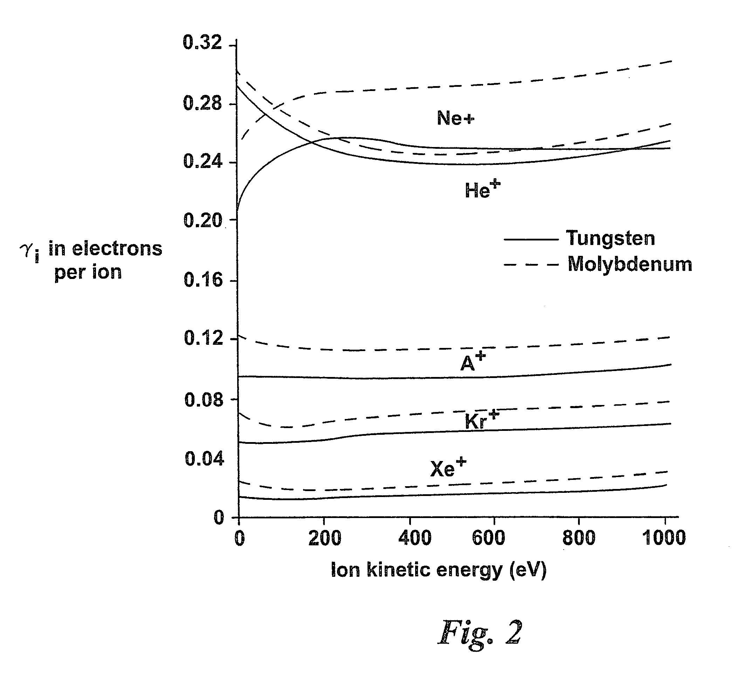

As can be seen from Figure 2, the secondary electron characteristics for various sputter gasses vary depending on the sputter gasses used. Thus He and Ne have higher levels of secondary electron emission as compared to heavier gasses such as Ar and Kr. The Applicants therefore appreciated that sputtering with He or Ne instead of Ar was likely to result in more secondary electrons emitted from the target and hence ionisation fraction.

This effect has been investigated by the Applicants by progressively introducing increased levels of helium flow and reducing the argon flow using a copper target and it would be seen that as the He is increased and the Ar is reduced the current increases due to formation of secondary electrons at the target surface. The presence of a low level of argon was discovered to be necessary to maintain film density quality.

### Experiments

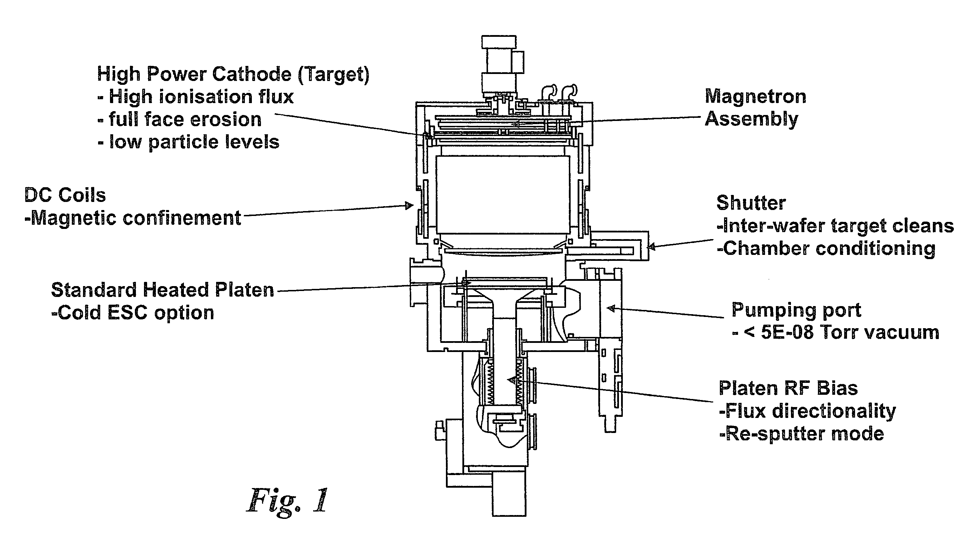

The Applicants then carried out an experiment using the apparatus of Figure 1 with the process condition shown in Table 1 below.

**Table 1**

| Parameter | Std process | He/Ar process |
|---|---|---|
| DC Power (kW) | 16 | 16 |
| Upper coil (A) | 15 | 15 |
| Lower coil (A) | 7 | 10.5 |
| Ar (sccm) | 100 | 7 |
| He (sccm) | 0 | 140 |
| Pressure (mT) | 5.97 | 5.02 |
| RF bias power (W) | 335 | 500 |
| Platen DC bias (V) | 245 | 275 |

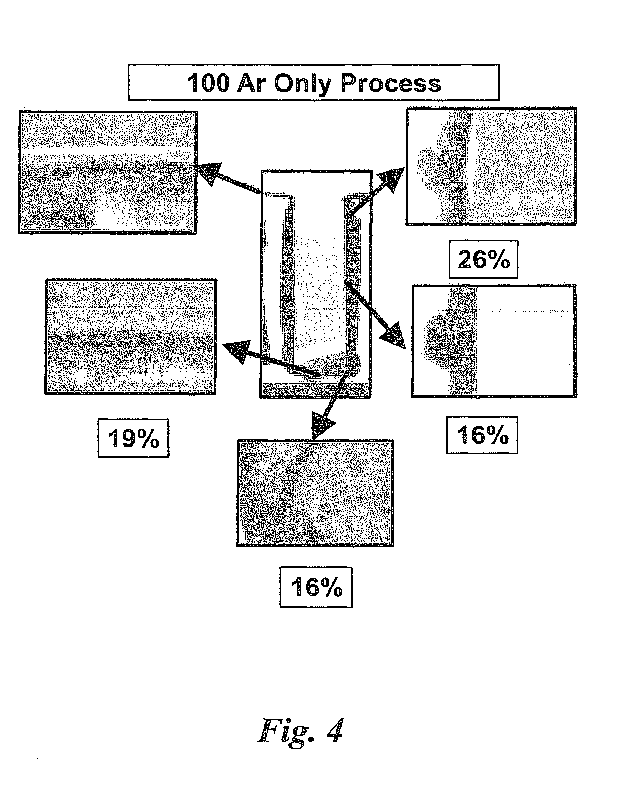

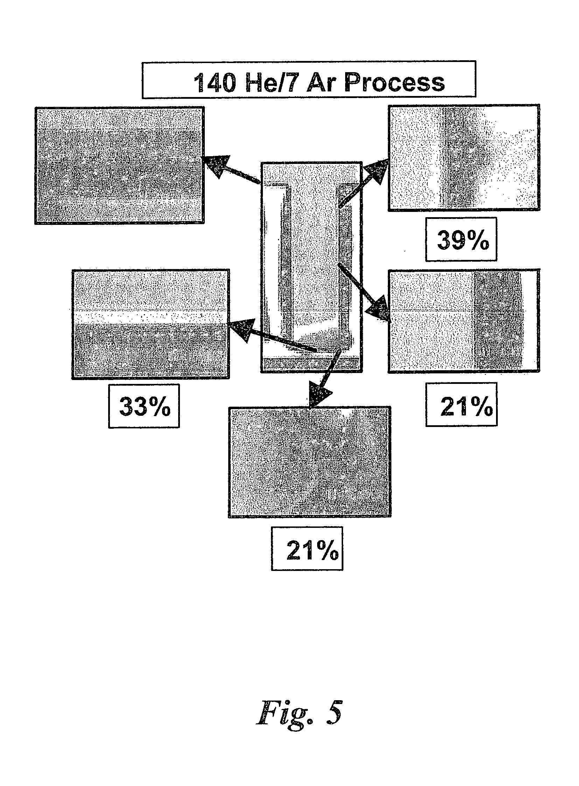

This compared a standard argon only process run on the apparatus of Figure 1 and an He/Ar process where the Ar flow was 7 sccm whereas the He flow was 140 sccm. The resultant coverage for the first process is shown in Figure 4, whilst for the second process the coverage is illustrated in Figure 5. The resultant step coverage is summarised in Table 2 below.

It will be seen that the He/Ar process shows a 5% absolute, 30% proportional, increase in sidewall coverage over the Ar only process value.

It can be seen from Table 1 that the platen DC bias is increased by only 30V (12%) with the He/Ar process, despite the RF power applied to the platen having been increased by 165W (50%) compared with the Ar only (standard) process. This shows that the He/Ar process has a higher level of ionisation, since the positive ions in the plasma will tend to reduce the negative DC bias achieved at the platen.

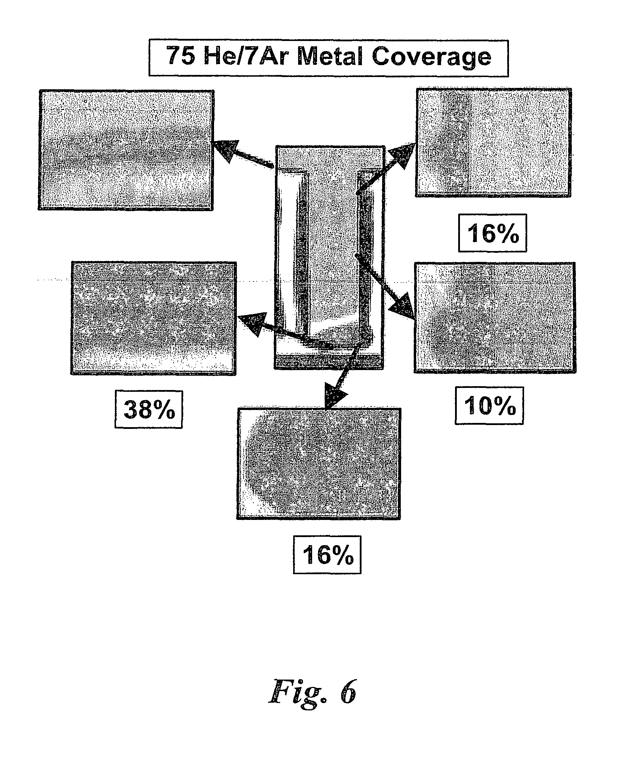

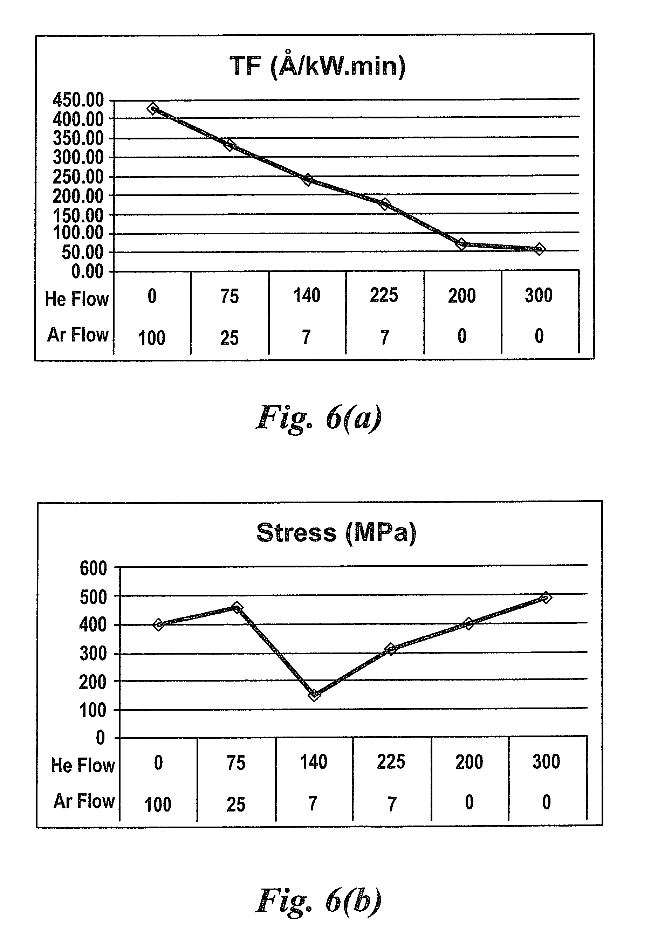

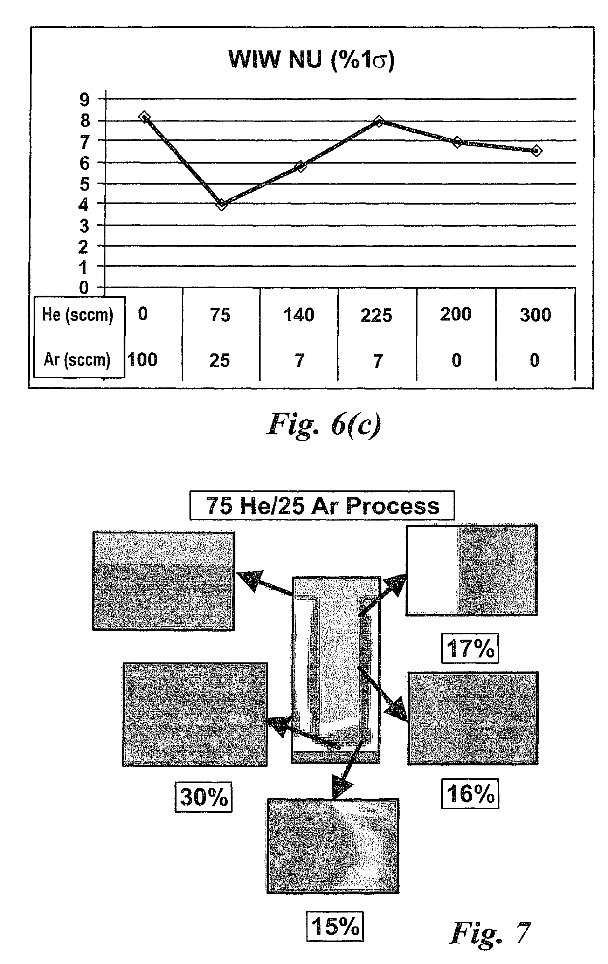

In Figure 6 the same process was run but this time with a 75 He sccm flow and the results are summarised in Table 3 below,

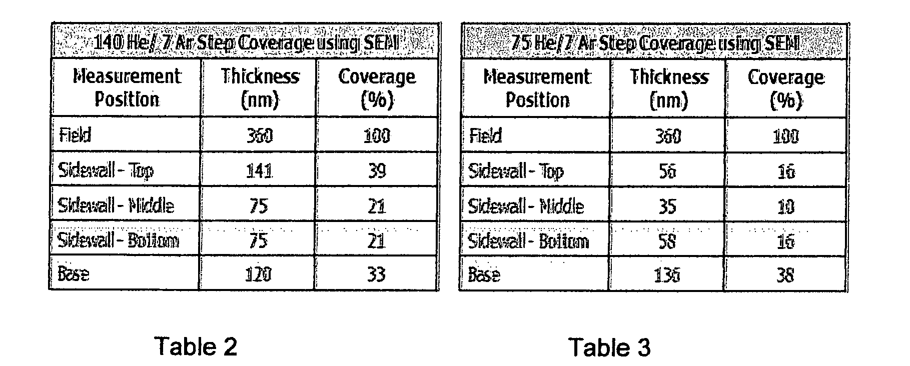

From this it will be seen that reducing the He flow results in reduced sidewall coverage both as compared to the 140 He/7Ar process and the Ar only process. This is because in this experiment the secondary electrons produced in the plasma were reduced due to the lower He flow.

Experiments have shown that <10 Sccm Ar is required to maintain the plasma and allow the sputtering of the Cu target to occur. Conversly He flows > 100 Sccm are required to help maintain the plasma and provide additional secondary electrons to enhance the sputtering effect at the bottom of the structure and so improve sidewall coverage.

In further experiments the deposition rate stress and within wafer non uniformity were monitored with varying flows and the results are shown respectively in Figures 6A to C. It will be seen that although the deposition rate drops with the addition of He the 7Ar/140He process is still high enough from production purposes. This combination has a particularly good stress value and an exceptable uniformity. It will be appreciated that reduced film stress helps to prevent delamination of the Cu film from the underlying materials.

Figure 7 illustrates a reduced helium flow with an increased argon flow and again the step coverage is reduced as is shown in Table 4 below.

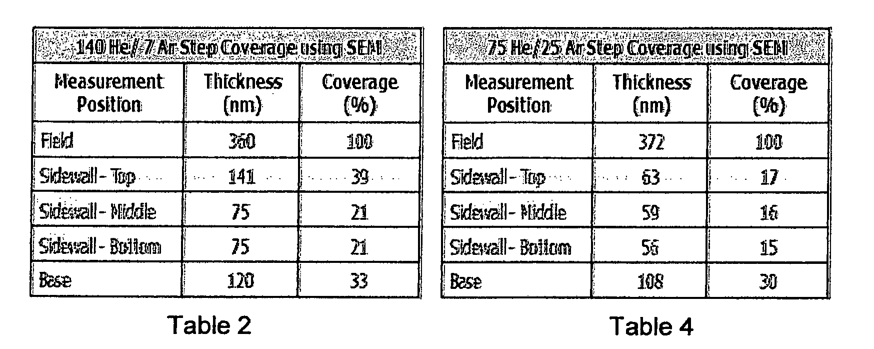

Accordingly in summary it is seen that considerable improvements can be achieved by having helium flow rates above about 100 sccm and argon flow rates below about 10 sccm. The 7Ar/140He resulted in a particularly preferred process for the reasons indicated above.

It may in fact be more generally applicable to speak about the partial pressures of the gases as these should relatively remain relative constant in terms of the performance achieved, whilst the actual flow rates may vary from chamber to chamber. Table 5 below sets out the equivalent partial pressures for the experimental flow rates.

**Table 5**

| Ar Flow (sccm) | He Flow (sccm) | TOTAL Pressure (mT) | Ar Partial Pressure (mT) | He Partial Pressure (mT) |
|---|---|---|---|---|
| 100 | 0 | 6.0 | 6.0 | 0.0 |
| 7 | 140 | 6.2 | 0.3 | 5.9 |
| 7 | 75 | 3.5 | 0.3 | 3.2 |
| 25 | 75 | 4.7 | 1.2 | 3.5 |

The metal used in the experiments was copper. The invention process would be similar for Titanium, Tantalum, Gold or Ruthenium.

## Claims

1. A method of plasma vapour deposition of metal into a recess in a workpiece in a manner to achieve re-sputtering of the metal at the base of the recess on to the sidewalls by sputtering a metal target with a sputter gas **characterised in that** the sputter gas is a mixture of Ar gas and He and/or Ne gas wherein the ratio He and/or Ne:Ar is at least 10:1.

2. A method as claimed in claim 1 wherein the ratio is 20:1.

3. A method as claimed in claim 1 wherein the flow rate of Ar <10 sccm and the flow rate of He and/or Ne > 100 sccm.

4. A method as claimed in claim 3 wherein the He flow rate is about 140 sccm and the Ar flow rate is about 7 sccm.

5. A method as claimed in any one of the preceding claims wherein the metal is selected from Copper, Titanium, Tantalum, Gold or Ruthenium.

6. A method as claimed in any one of the preceding claims wherein the mix of He and/or Ne and Ar is such that the target current density is 0.035 A/cm².

## Patentansprüche

1. Verfahren zur Plasma-Dampfabscheidung von Metall in eine in einem Werktisch befindliche Vertiefung in einer Weise, die zu einem Zurückspritzen des Metalls am Boden der Vertiefung zu den Seitenwänden führt, dadurch, daß ein metallenes Ziel mit einem Zerstäubungsgas zerstäubt wird, **dadurch gekennzeichnet, daß** das Zerstäubungsgas eine Mischung aus Argon-Gas und Helium und / oder Neon-Gas ist, wobei das Verhältnis von Helium und / oder Neon zu Argon wenigstens 10 : 1 beträgt.

2. Verfahren nach Anspruch 1, **dadurch gekennzeichnet, daß** das Verhältnis 20 : 1 beträgt.

3. Verfahren nach Anspruch 1, **dadurch gekennzeichnet, daß** die Strömungsgeschwindigkeit von Argon < 10 cm³ / min ist und die Strömungsgeschwindigkeit von Helium und / oder Neon > 100 cm³ / min ist.

4. Verfahren nach Anspruch 3, **dadurch gekennzeichnet, daß** die Helium-Strömungsgeschwindigkeit etwa 140 cm³ / min beträgt und die Argon-Strömungsgeschwindigkeit etwa 7 cm³ / min beträgt.

5. Verfahren nach einem der vorhergehenden Ansprüche, **dadurch gekennzeichnet, daß** das Metall aus Kupfer, Titan, Tantal, Gold oder Ruthenium ausgewählt wird.

6. Verfahren nach einem der vorhergehenden Ansprüche, **dadurch gekennzeichnet, daß** das Gemisch aus Helium und / oder Neon und Argon derart ist, daß die Zielstromdichte 0,035 A / cm² beträgt.

## Revendications

1. Procédé de dépôt de vapeur de plasma d'un métal dans un évidement situé dans une pièce de fabrication de manière à accomplir une repulvérisation cathodique du métal à la base de l'évidement sur les parois latérales par pulvérisation cathodique d'une cible de métal avec un gaz de pulvérisation cathodique, **caractérisé en ce que** le gaz de pulvérisation cathodique est un mélange de gaz Ar et de gaz He et/ou Ne, dans lequel le rapport He et/ou Ne : Ar est d'au moins 10 : 1.

2. Procédé selon la revendication 1, dans lequel le rapport est de 20 : 1.

3. Procédé selon la revendication 1, dans lequel le débit de Ar < 10 sccm et le débit de He et/ou Ne > 100 sccm.

4. Procédé selon la revendication 3, dans lequel le débit de He est d'environ 140 sccm et le débit de Ar est d'environ 7 sccm.

5. Procédé selon l'une quelconque des revendications précédentes, dans lequel le métal est choisi parmi le cuivre, le titane, le tantale, l'or ou le ruthénium.

6. Procédé selon l'une quelconque des revendications précédentes, dans lequel le mélange de He et/ou Ne et de Ar est tel que la densité de courant cible est de 0,035 A/cm².
